# EUROPEAN PATENT APPLICATION

(11) **EP 4 117 019 A1**
(43) Date of publication of application: **11.01.2023**
(21) Application number: 21184454.3
(22) Date of filing: 08.07.2021
(51) Int. Cl.: H01L 21/02

(54) **SEMICONDUCTOR STRUCTURE**

(71) Applicant: Imec VZW, 3001 Leuven (BE); Katholieke Universiteit Leuven KU Leuven Research & Development, 3000 Leuven (BE)
(72) Inventor: HEILMANN, Martin, 3001 Heverlee (BE); ZHAO, Ming, 3060 Bertem (BE); COLLAERT, Nadine, 3052 Blanden (BE); PARVAIS, Bertrand, 1457 Nil-Saint-Vincent (BE); YADAV, Sachin, 3001 Leuven (BE)
(74) Representative: DenK iP bv

(57) **Abstract**

A method for manufacturing a semiconductor structure comprising a III-V semiconductor device in a first region (11) of a base substrate (1) and a further device (6) in a second region (12) of the base substrate (1), the method comprising: a. obtaining a base substrate (1) comprising the first region (11) and the second region (12), different from the first region (11), b. providing a buffer layer (2) over a surface of the base substrate (1) at least in the first region (11), wherein the buffer layer (2) comprises at least one monolayer of a first two-dimensional layered crystal material, c. forming, over the buffer layer (2) in the first region (11), and not in the second region (12), a III-V semiconductor material (4), and d. forming, in the second region (12), at least part of the further device (6).

## Description

### Technical field of the invention

The present invention relates to a semiconductor structure and a method for forming the semiconductor structure.

### Background of the invention

There is an increasing interest to integrate III-V semiconductor devices with further devices, e.g., further semiconductor devices, typically incorporating a non-III-V material such as Si, on the same base substrate. Combining the III-V semiconductor devices and further devices in a hybrid semiconductor structure may combine the advantages of both types of devices.

III-V semiconductor devices in radio-frequency (RF) integrated circuits typically have higher power, linearity, and efficiency characteristics when compared to, e.g., Si-based semiconductor devices. This is especially true for telecommunication standards at millimeter wave frequencies, such as used in the 5G and 6G telecommunication standards. Furthermore, FinFET-type III-V semiconductor devices are suitable for scaling above 100 GHz and typically have good linearity performance.

On the other hand, further devices made of different materials than III-V materials may provide other advantages. In particular Si-based semiconductor devices, such as used in Si-CMOS, are relatively low in price, and provide a high transistor density, a mature back-end-of-the-line (BEOL), and at present the best technology option for digital baseband.

The combined advantages of III-V semiconductor devices and further devices are best exploited when said devices are separated by distances smaller than a micron. Thereby, for example, a high density and good communication between the III-V semiconductor devices and further semiconductor devices may be achieved. Therefore, it is preferred to provide, i.e., integrate, the III-V semiconductor devices and further devices on one and the same base substrate, e.g., on a single Si wafer.

This is, however, far from straightforward. Firstly, III-V-based RF device stacks are typically grown as thick layers on high-resistivity Si(111). On the other hand, Si devices are typically fabricated on doped Si(100). III-V materials grow as polycrystalline layers on Si(100). Such polycrystalline layers are not fit for devices.

The formation of III-V materials on Si(111) is, however, also problematic. This is mainly due to lattice and thermal mismatches. To overcome such mismatches, a complicated, thick strain relaxing buffer layer may be provided. Even then, however, the crystalline defect density (such as threading dislocations and anti-phase boundaries) is still relatively high in the top active region of the III-V material.

Furthermore, for example, Ga (which is a III-type material often used in III-V semiconductor devices) forms a eutectic alloy with Si (which is typically used as substrate) at elevated temperatures. For example, this may result in the etching of the Si substrate during the growth of GaN. Although an AlN nucleation layer may be grown on Si(111), on which the GaN may be grown, Al, Ga, or N may still diffuse into the insulating Si. Thereby, for example, unwanted conducting channels may be formed in Si. Furthermore, AlN is very problematic to grow selectively due to low surface diffusivity and desorption.

In addition, due to the high growth temperatures required for growing III-V materials, the III-V material must be grown before Si-CMOS is fabricated. Finally, thick buffer layers of III-V are problematic. Exposing the Si for the subsequent CMOS fabrication would require the etching of deep trenches. However, highly scaled Si-CMOS devices cannot be fabricated in deep trenches.

There is, therefore, a need in the art for a semiconductor structure combining a III-V semiconductor device and a further device on the same base substrate, and a method for forming said structure, that overcomes at least partially one or more of the above problems.

### Summary of the invention

It is an object of the present invention to provide a good method for manufacturing a semiconductor structure comprising a III-V semiconductor device and at least part of a further device on a base substrate, and a semiconductor structure manufactured thereby.

The above objective is accomplished by a method and device according to the present invention.

It is an advantage of embodiments of the method of the present invention that the growth of a III-V semiconductor material is independent of the type of base substrate used. It is an advantage of embodiments of the present invention that the III-V semiconductor device may be combined with a Si-type further semiconductor device on the same base substrate. It is an advantage of embodiments of the present invention that there is no need for any wafer bonding or silicon on insulator substrates for the integration.

The III-V semiconductor material is formed on a first two-dimensional layered crystal material over the base substrate. It is an advantage of embodiments of the present invention that, thereby, the III-V semiconductor is grown via van der Waals epitaxy. It is an advantage of embodiments of the present invention that, thereby, restrictions due to lattice and thermal mismatch are reduced. It is an advantage of embodiments of the present invention that simple and economic growth procedures may be achieved.

It is an advantage of embodiments of the present invention that III-V semiconductor devices and further devices are combined in a semiconductor structure. It is an advantage of embodiments of the present invention that many degrees of freedom are present for the semiconductor structure. The semiconductor structure may, therefore, be provided in the desired form and in a preferred density.

It is an advantage of embodiments of the present invention that the III-V semiconductor device may have a small thickness since a thick buffer layer is not required. It is an advantage of embodiments of the present invention that, thereby, the III-V semiconductor device may be combined with further devices, e.g., further semiconductor devices, such as with Si-based CMOS devices.

It is an advantage of embodiments of the present invention that two-dimensional layered crystal materials typically do not have out-of-plane dangling bonds. Thereby, good diffusion of adatoms is possible on the two-dimensional layered crystal materials. It is an advantage of embodiments of the present invention that high-quality nucleation layers for the III-V semiconductor material may be formed even at low temperatures. On substrates having dangling bonds, low temperature growth is typically inhibited by lack of surface mobility of adatoms due to the dangling bonds.

It is an advantage of embodiments of the present invention that the III-V semiconductor material can be grown at low temperatures as thin layers with high quality. It is an advantage of embodiments of the present invention that the III-V semiconductor material is not fixed by covalent bonds. Thereby, a thermal expansion mismatch between a base substrate and the III-V semiconductor material during cool down after growth of the III-V semiconductor material typically do not result in bowing or cracking of the base substrate. Bowing and cracking may be detrimental for the performance of a III-V semiconductor device and for further processing for forming Si CMOS structures.

It is an advantage of embodiments of the present invention that due to the selective growth, the III-V semiconductor material has exposed sidewalls. Thereby, if there is still strain present during cooldown despite the lack of dangling bonds of the two-dimensional layered crystal material, this strain may relax towards the exposed sidewalls of the selectively grown III-V semiconductor material. It is an advantage of embodiments of the present invention that, even if threading dislocations or other crystal defects form during the growth (e.g., at low temperatures), they can be removed by post-growth annealing.

In a first aspect, the present invention relates to a method for manufacturing a semiconductor structure comprising a III-V semiconductor device in a first region of a base substrate and at least part of a further device, e.g., a further semiconductor device, in a second region of the base substrate, the method comprising: a. obtaining a base substrate comprising the first region and the second region, different from the first region, b. providing a buffer layer over a surface of the base substrate at least in the first region, wherein the buffer layer comprises at least one monolayer of a first two-dimensional layered crystal material, c. forming, over the buffer layer in the first region, and not in the second region, a III-V semiconductor material, and d. forming, in the second region, at least part of the further device.

In a second aspect, the present invention relates to a semiconductor structure comprising: a base substrate comprising a first region and a second region, a buffer layer over a surface of the base substrate at least in the first region, wherein the buffer layer comprises at least one monolayer of a first two-dimensional layered crystal material, a III-V semiconductor material over the buffer layer in the first region, and at least part of a further device in the second region. The semiconductor structure of the second aspect is typically obtainable by the method of the first aspect.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1A, FIG. 2A, FIG. 3A, FIG. 4A, and FIG. 5 are schematic vertical cross-sectional representations of steps in a first exemplary method according to embodiments of the present invention.
FIG. 1B, FIG. 2B, FIG. 3B, FIG. 4B, are schematic top-view representations of steps in a first exemplary method according to embodiments of the present invention.
FIG. 6, FIG. 7, and FIG. 8 are schematic vertical cross-sectional representations of steps in a second exemplary method according to embodiments of the present invention.
FIG. 9, FIG. 10, and FIG. 11 are schematic vertical cross-sectional representations of steps in a third exemplary method according to embodiments of the present invention.
FIG. 12, FIG. 13, and FIG. 14 are schematic vertical cross-sectional representations of steps in a fourth exemplary method according to embodiments of the present invention.
FIG. 15 is a schematic vertical cross-sectional representation of a step in a fifth exemplary method according to embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third, and the like in the description and in the claims, are used for distinguishing between similar elements and not necessarily for describing a sequence, either temporally, spatially, in ranking, or in any other manner. It is to be understood that the terms so used are interchangeable under appropriate circumstances and that the embodiments of the invention described herein are capable of operation in other sequences than described or illustrated herein.

Moreover, the terms top, bottom, over, under, and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps, or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used herein, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures, or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures, and techniques have not been shown in detail in order not to obscure an understanding of this description.

Reference will be made to transistors. These are devices having a first main electrode such as a drain, a second main electrode such as a source, and a control electrode such as a gate for controlling the flow of electrical charges between the first and second main electrodes.

Reference is made to two-dimensional layered crystal materials. Two-dimensional layered crystal materials are known in the art as layered materials, as two-dimensional materials, and as single-layer materials. Two-dimensional layered crystal materials are solid materials. The material comprises one or more two-dimensional layers, i.e., monolayers. Herein, the term "two-dimensional" refers to the fact that two dimensions of each layer are much larger than a third dimension. Each monolayer is typically crystalline. Along the third dimension, each layer (i.e., each monolayer) of the material comprises typically up to three atomic layers. Examples of two-dimensional layered crystal materials are metal dichalcogenides, wherein each layer of the material comprises three atomic layers along the third dimension. That is, metal dichalcogenides comprise a layer of metal atoms between two chalcogenide layers. Other examples are graphene and hexagonal boron nitride, wherein each layer of the material comprises one atomic layer along the third dimension. Typically, covalent bonds exist between atoms within each layer of the layered material. Coupling between adjacent layers in a two-dimensional layered crystal material is typically due to van der Waals bonding, and, typically, no covalent bond is present between adjacent layers. Typically, surfaces of two-dimensional layered crystal materials do not have dangling, i.e., free, bonds.

In a first aspect, the present invention relates to a method for manufacturing a semiconductor structure comprising a III-V semiconductor device in a first region of a base substrate and at least part of a further device, e.g., a further semiconductor device, in a second region of the base substrate, the method comprising: a. obtaining a base substrate comprising the first region and the second region, different from the first region, b. providing a buffer layer over, e.g., on (i.e., in physical contact with), a surface of the base substrate at least in the first region, wherein the buffer layer comprises at least one monolayer of a first two-dimensional layered crystal material, c. forming, over, e.g., on, the buffer layer in the first region, and not in the second region, a III-V semiconductor material, and d. forming, in the second region, at least part of the further device.

The first region may have any shape suitable for forming the III-V semiconductor device thereover. The second region may have any shape suitable for forming the further device thereover. In embodiments, the first region has a first extent, e.g., a length, of from 0.1 to 500 micrometre in a first direction, and a second extent, e.g., a width, of from 0.1 to 500 micrometre in a second direction, perpendicular to the first direction. In embodiments, the second region has a first extent, e.g., a length, of from 0.1 to 500 micrometre in a first direction, and a second extent, e.g., a width, of from 0.1 to 500 micrometre in a second direction, perpendicular to the first direction. In embodiments, a distance between the first and second region is smaller than 2 µm, preferably from 10 nm to 1 µm, such as from 50 nm to 200 nm. In embodiments, a distance between the III-V semiconductor device and the further device may be smaller than 2 µm, preferably from 10 nm to 1 µm, such as from 50 nm to 200 nm. It is an advantage of embodiments of the present invention that a good communicative coupling between the III-V semiconductor device and the further device, e.g., the further semiconductor device, may be achieved.

The III-V semiconductor device may be any device that uses a III-V semiconductor material for it to function, such as a diode or a transistor. In embodiments, the III-V semiconductor device is a transistor, such as a field-effect transistor. In embodiments, a channel of the transistor can be formed in the III-V semiconductor material. Typically, the III-V semiconductor material comprises at least two layers: a III-V buffer layer (e.g. GaN) and a III-V active layer (e.g. GaN), over and preferably on the III-V buffer layer. Typically, the buffer layer is grown until a single-crystalline and coalesced layer is formed as its top surface. In embodiments, the active layer may comprise a III-V channel layer and a barrier layer having a larger bandgap than the III-V channel layer. In embodiments, the III-V semiconductor material may comprise a nucleation layer (e.g. AlN) at the base of the III-V buffer layer. In embodiments, the III-V semiconductor material may comprise one or more III-N semiconductor materials, preferably one or more of GaN, AlN, InN, AlGaN, InGaN, InAlN, and GaInAlN. In preferred embodiments, the III-V semiconductor material may comprise a ternary or quaternary compound. The ternary or quaternary compound is typically used as a barrier layer. More preferably, it may comprise one of AlGaN, InGaN, InAlN, and GaInAlN. It is an advantage of embodiments of the present invention that using ternary or quaternary compounds may yield good III-V semiconductor devices. For example, if the ternary or quaternary compound is used as barrier layer, strain with respect to the buffer layer may be well controlled, while providing a good bandgap offset with respect to the buffer layer.

The further device may be a further semiconductor device, but the present invention is not limited thereto. For example, the further device may be a capacitor structure. In the case of a capacitor structure, the further device comprises two conducting layers, e.g., graphene, separated by an electrically insulating layer, e.g., hexagonal boron nitride. In preferred embodiments, the further device is a further semiconductor device. The further semiconductor device may be any device that uses a semiconductor material, other than a III-V material, for it to function, such as a diode or a transistor. In embodiments, the further semiconductor device is a transistor, such as a field-effect transistor. The further semiconductor device typically comprises a semiconductor material that is different from a III-V semiconductor material, such as a group IV semiconductor material (typically silicon or germanium) or a second two-dimensional layered crystal material.

In embodiments wherein the further device is the further semiconductor device, the at least part of the further semiconductor device comprises a silicon semiconductor material or at least one monolayer, e.g., from 1 to 100 monolayers, of a second two-dimensional layered crystal material. The second two-dimensional layered crystal material may be independently selected from the materials mentioned with respect to the first two-dimensional layered crystal material.

In embodiments, step d comprises forming the second two-dimensional layered crystal material in the second region. In embodiments, the at least part of the further device may be a contact, e.g., gate contact, of the further device. In embodiments, such as when the second two-dimensional layered crystal material is a conductor, e.g., graphene, the second two-dimensional layered crystal material may form a gate contact of the further device. In embodiments, such as when the second two-dimensional layered crystal material is an electrical insulator, e.g., hexagonal boron nitride, the second two-dimensional layered crystal material may form a gate dielectric of the further device. In embodiments, such as when the second two-dimensional layered crystal material is a semiconductor, e.g., a transition metal dichalcogenide, the second two-dimensional layered crystal material may form a channel layer of the further device. In particular embodiments, the further device is a transistor comprising a stack of three different two-dimensional layered crystal materials, comprising a two-dimensional layered crystal material that is a semiconductor, a two-dimensional layered crystal material that is an electrical insulator over the semiconductor, and a two-dimensional layered crystal material that is a conductor over the electrical insulator. In embodiments, the at least part of the further device comprises at least part of the buffer layer in the second region, i.e., the second two-dimensional layered crystal material comprises at least part of the buffer layer in the second region. In these embodiments, the second two-dimensional layered crystal material and the first two-dimensional layered crystal material comprise a same material. In these embodiments, the forming step d may comprise removing part of the first two-dimensional layered crystal material so as to form the at least part of the further device in the second region. In other words, step d may comprise removing part of the first two-dimensional layered crystal material so as to separate the first two-dimensional layered crystal material in two spatially separated two-dimensional layered crystal materials: the first two-dimensional layered crystal material and the second two-dimensional layered crystal material. Herein, the removing may be performed on part of the first two-dimensional layered crystal material that is in the second region or not in the second region. It is an advantage of embodiments of the present invention that no additional steps of depositing or transferring the second two-dimensional layered crystal material are required. In embodiments wherein the further device is a further semiconductor device, step d of forming the at least part of the further semiconductor device may comprise any technique known to the skilled person with respect to Si CMOS fabrication. For example, step d may comprise forming a Si-based P-type metal oxide transistor. Techniques that may be used for forming the Si-based P-type metal oxide transistor are well-known to the skilled person. Preferably, step d is performed after step c. Thereby, the forming of the III-V semiconductor material, which may require high temperatures, may not damage the at least part of the further device.

As the III-V semiconductor material is grown over the buffer layer, the base substrate may not influence the growth of the III-V material. Therefore, the base substrate may comprise any type of material. In embodiments, the base substrate comprises, e.g., consists of, a germanium or silicon wafer. In preferred embodiments, the base substrate comprises crystalline silicon, such as Si(111) or Si(100), preferably Si(100). In embodiments, the base substrate comprises silicon oxide or silicon nitride covering the crystalline silicon, e.g. Si(100). In these embodiments, the buffer layer may be formed over, e.g., on, the silicon oxide or silicon nitride. In embodiments, the base substrate comprises doped silicon. This is particularly preferred for the formation of a Si-based device (i.e. a device having a Si active layer) for the further, semiconductor, device, for which, typically, doped silicon is used. The surface of the base substrate is typically flat, but the invention is not limited thereto.

In embodiments, providing the buffer layer comprises providing the buffer layer over a surface of the base substrate in the first region and in the second region. In these embodiments, the buffer layer may also be provided over a surface of the base substrate outside of the first region and the second region, for example over a surface separating the first region and the second region. In embodiments, the buffer layer is a continuous, i.e., non-intermittent, layer. It is an advantage of embodiments of the present invention that no selective growth of the buffer layer may be required. It is an advantage of embodiments of the present invention that the buffer layer in the second region may function as part of the further device.

In embodiments, the method comprises a step a' after step a, and before step c of: a'. forming a dielectric mask layer over the surface of the base substrate in the second region and not in the first region. In embodiments, the dielectric mask layer has a thickness of from 5 nm to 1000 nm. In embodiments, the dielectric mask layer is formed over a surface of the base substrate separating the first region and the second region. The dielectric mask layer may act as a mask for subsequent growth of the III-V semiconductor material. That is, the III-V semiconductor material only grows on exposed surfaces of the base substrate, uncovered by the dielectric mask layer. In embodiments, the dielectric mask layer comprises a silicon nitride or a silicon oxide. In embodiments, the dielectric mask layer is formed on, i.e., in physical contact with, the surface of the base substrate. In these embodiments, step a' is typically performed before step b. It is an advantage of embodiments of the present invention that the dielectric mask layer may act as a mask for the formation, e.g., the growth, of the buffer layer on surfaces of the base substrate uncovered by the dielectric mask layer. In different embodiments, the dielectric mask layer is formed on, i.e., in contact with, the buffer layer. In embodiments, the method comprises a step c'", preferably before step d, preferably after step c, of removing the dielectric mask layer.

In embodiments, the method comprises a step a" after step a, and before step b, of: a" depositing the dielectric mask layer in the first region and in the second region. In these embodiments, in step b, the buffer layer may be provided over, e.g., on, the dielectric mask layer, preferably in the first region and not in the second region, preferably not in a region separating the first region from the second region. It is an advantage of embodiments of the present invention that, in step c, the III-V semiconductor material is only formed over, e.g., on, the buffer layer, and not on the dielectric mask layer not covered by the buffer layer.

In embodiments where the buffer layer is provided over a surface of the base substrate in the first region and in the second region, the method may comprise a step b' after step b and before step c of: b'. introducing crystallographic defects in the buffer layer in the first region and not in the second region. The crystallographic defects may be introduced, for example, by application of a laser beam, an electron beam, an ion beam, e.g., with He, Ga, or Xe ions, or a plasma. Preferably, a plasma is applied. Alternatively, the defects may be introduced by NH₃ and H₂ treatment. The crystallographic defects may function as nucleation sites for growth of the III-V semiconductor material. Thereby, the III-V semiconductor material may grow at a higher rate on part of the buffer layer comprising the crystallographic defects than on part of the buffer layer not comprising the crystallographic defects, e.g., on pristine buffer layer. As a result, the III-V semiconductor material layer selectively grows on part of the buffer layer comprising the crystallographic defects.

In embodiments, the method comprises a step c' after step c of: c'. reducing an interface area between the surface of the base substrate in the first region and a surface of the buffer layer in the first region. Typically, the interface area is defined by a top surface of the base substrate contacting a bottom surface of the buffer layer. In embodiments, the interface area is reduced by removing at least part of the base substrate in the first region contacting the buffer layer. In embodiments, the base substrate is selectively removed, selectively with respect to the buffer layer, and preferably selectively with respect to the III-V semiconductor structure. In embodiments, the base substrate is selectively removed by selective etching. In embodiments, the selective etching comprises wet etching, for example, using HF as etchant. HF may selectively etch the base substrate, e.g., SiO₂, with respect to Si, graphene, and GaN. In embodiments, the selective etching comprises plasma etching, using, for example, a fluorine containing plasma. The fluorine containing plasma may remove SiN selectively with respect to SiO₂ or Si. It is an advantage of embodiments of the present invention that, by reducing the interface area, an energy loss from the III-V semiconductor device to the base substrate may be reduced. This may be particularly advantageous when the buffer layer comprises graphene. For example, an insulating buffer layer, such as hexagonal boron nitride, may be used to limit the energy loss. In embodiments wherein the buffer layer is formed on and above a surface of the dielectric mask layer, the interface area may, instead, be an interface area between the surface of the dielectric mask layer and a surface of the buffer layer. In embodiments, the interface area is reduced, in step c', by at least 1%, such as from 5 to 100%, such as from 5% to 80%. The reducing of the interface area may result in a gap between the top surface of the base substrate (or of the dielectric mask layer if the buffer layer is formed on a surface of the dielectric mask layer) and the bottom surface of part of the buffer layer, which is typically free of solid material. The gap may have a length of from 10 nm to 5000 nm.

In embodiments, the method comprises a step c" after step c and preferably before step d of: c". forming a protective layer over the III-V semiconductor material. In embodiments, the protective layer covers at least a top surface of the III-V semiconductor material, preferably also side surfaces of the III-V semiconductor material. The protective layer preferably comprises a silicon nitride or a silicon oxide. In embodiments, the protective layer is formed by chemical vapor deposition. In embodiments, step c'" of removing the dielectric mask layer is performed after step c". In embodiments, the protective layer has a thickness of from 20 to 1000 nm. In embodiments, the protective layer is thicker than the dielectric mask layer. This may protect the III-V semiconductor material from being etched during the removing of the dielectric mask layer. In embodiments, the dielectric mask layer is a different material than the protective layer. For example, one of the dielectric mask layer and the protective layer may comprise, e.g., consist of, silicon nitride and the other may comprise, e.g., consist of, silicon oxide. This may enable selective etching of the dielectric mask layer with respect to the protective layer. It is an advantage of embodiments of the present invention that the protective layer may protect the III-V semiconductor material from damage during the removal of the dielectric mask layer. It is an advantage of embodiments of the present invention that the protective layer may protect the III-V semiconductor material from damage due to step d of forming, in the second region, at least part of the further device.

In embodiments, the buffer layer comprises from 1 to 100 monolayers of the first two-dimensional layered crystal material. It is an advantage of embodiments of the present invention that the buffer layer may be thin, yet prevent the base substrate from influencing the growth of the III-V semiconductor material. Due to the absence of dangling bonds on the surface of the buffer layer, growth of the III-V semiconductor material may proceed according to the structure, e.g., crystal structure, of the III-V semiconductor material. It is an advantage of embodiments of the present invention that the growth of the III-V semiconductor material on the buffer layer is independent of the crystal structure of the first two-dimensional layered crystal material. In embodiments, the monolayer of the first two-dimensional layered crystal material comprises at least one of, preferably consists of at least one of, graphene, silicene, borophene, germanene, black phosphorus, hexagonal boron nitride, or a transition metal dichalcogenide monolayer. Preferably, the monolayer of the first two-dimensional layered crystal material comprises at least one of, preferably consists of at least one of, graphene, hexagonal boron nitride, or a transition metal dichalcogenide monolayer. In embodiments, the transition metal dichalcogenide monolayer is at least one of WTe₂, MoSe₂, WSe₂, MoTe₂, WS₂, or MoS₂, GaSe, GaTe, InSe, Bi₂Se₃, NbSe₂, NbS₂, TaS₂ TiS₂. NiSe₂, preferably WS₂ or MoS₂.

In embodiments, the buffer layer may be formed over the base substrate via transfer of the buffer layer. In these embodiments, the buffer layer is obtained from an external supply material, for example via mechanical exfoliation. That is, the at least one monolayer may be exfoliated from the external supply material, and transferred over the base substrate. Alternatively, the at least one monolayer is grown on a metal substrate different from the base substrate, thereby forming the external supply material. Subsequently, the at least one monolayer may be transferred via a wet chemical transfer or dry transfer technique. In different embodiments, the buffer layer is grown over the base substrate. For example, the buffer layer may be formed by chemical vapor deposition. The buffer layer may be formed on the base substrate, e.g., Si. Alternatively, the buffer layer may be formed on a metal layer deposited on the base substrate, e.g., Si. Herein, the metal layer may, subsequently, be removed selectively. In embodiments, the buffer layer may be formed using a chemical vapor deposition technique such as metal-organic vapour-phase epitaxy, molecular beam epitaxy, atomic layer deposition, or pulsed laser deposition.

In embodiments, step c comprises a step of depositing the III-V semiconductor material. In embodiments wherein the III-V semiconductor material is deposited on the buffer layer, step c may comprise a step, before depositing the III-V semiconductor material, of applying a plasma or an NH₃ and H₂ pre-treatment, to a top surface of the buffer layer. It is an advantage of embodiments of the present invention that homogeneous nucleation of the III-V semiconductor material may be achieved. Furthermore, the surface of the buffer layer may be cleaned in H₂, e.g., to remove any contaminations introduced during transfer or formation of the buffer layer. In embodiments, step c of forming the III-V semiconductor material comprises forming an active III-V material on the buffer layer, such as at a temperature of from 1000°C to 1300°C, preferably from 1200°C to 1300°C. In embodiments, step c of forming the III-V semiconductor material comprises the steps of: c1. Depositing a buffer III-V material at a temperature of from 1000 to 1200 °C, and c2. depositing an active III-V material on the buffer III-V material at a temperature of from 1000 °C to 1300 °C, preferably from 1210 to 1300°C. In these embodiments, step c2 is typically performed at a higher temperature than step c1. As step c1 may be performed at a low temperature, adatoms on the buffer layer may have a low desorption rate. Therefore, a high nucleation density on the buffer layer may be achieved. Thereby, a homogeneous, e.g., continuous, buffer III-V material may be obtained. Furthermore, a faster formation of the buffer III-V material may be achieved. Step c2 may have a high growth rate for, and yield a low amount of defects in, the active III-V material. However, the invention is not limited thereto, and instead, only the active III-V material may be deposited. In embodiments, step c1 may be performed, instead, at a temperature below 1000°C, such as below 700°C, most preferably below 500°C. In embodiments, step c2 may be performed, instead, at a temperature below 1000°C, such as below 700°C, most preferably below 500°C. For example, particular precursors, such as hydrazine or tri-ethyl gallium, may enable lower temperature formation, i.e., epitaxial growth, of III-V material, e.g., buffer III-V material of active III-V material. It is an advantage of embodiments of the present invention, that low-temperature processes may induce less damage to other structures. Preferably, the buffer III-V material has a monocrystalline structure. It is an advantage of embodiments of the present invention that forming the buffer layer may result in the growth of a low defect, e.g., monocrystalline, buffer III-V material. The buffer III-V material may be semiconducting. The buffer III-V material may have a larger defect density than the active III-V material. That may be as the buffer III-V material is formed on the buffer layer, and at a lower temperature. However, preferably, the defect density is the same for the buffer III-V material and the active III-V material. The active III-V material typically has a monocrystalline structure, such as a diamond lattice or a hexagonal lattice, e.g., a wurtzite lattice. In embodiments, in step c1, less than 1000 nm, preferably less than 200 nm, more preferably less than 50 nm, of the buffer III-V material is deposited. In embodiments, in step c1, at least 1 nm, such as at least 10 nm, of the buffer III-V material is deposited. It is an advantage of embodiments of the present invention that the amount of buffer III-V material that has to be deposited is limited. Thereby, a distance between the active III-V material and the further device may be limited. In embodiments, in step c2, from 10 nm to 1000 nm of active III-V material is deposited.

In particular embodiments, the buffer III-V material may be formed on the surface of the base substrate in the first region. In these embodiments, the buffer layer may be formed on the buffer III-V material. In these embodiments, the active III-V semiconductor material, e.g., a monocrystalline III-V semiconductor material, may be deposited on the buffer layer. In these embodiments, the buffer layer may function as a back gate contact of a III-V semiconductor device. In alternative embodiments, a III-V buffer material, instead of the active III-V semiconductor material, may be deposited on top of the buffer layer. In these embodiments, the buffer layer may form a device, embedded in III-V material, wherein an active III-V semiconductor material may be also grown on top to form a III-V semiconductor device. The resulting structure would have a buffer III-V material on top of a base substrate, a buffer layer on top of the buffer III-V material, a buffer III-V material on top of the buffer layer, and an active III-V semiconductor material on top of the buffer III-V material.

In embodiments, step c comprises a step c3 of: c3. forming a mask comprising a pattern over the III-V semiconductor material, and transferring the pattern into the III-V semiconductor material and, preferably, into the buffer material underneath the III-V semiconductor material. In embodiments, the transferring of the pattern comprises performing etching techniques, such as dry or wet etching techniques, preferably a dry etching technique. In embodiments, the dry etching comprises reactive ion etching. In these embodiments, wet etching may be performed after the reactive ion etching, e.g., KOH when the III-V semiconductor material is GaN. This may remove any surface damage introduced in sidewalls of the III-V semiconductor material. In embodiments, the transferring of the pattern comprises performing lithography, such as extreme-UV lithography or electron beam lithography. In embodiments comprising steps c1 and c2, step c3 is performed after c1 and c2. In embodiments, c3 comprises removing the buffer material in the second region, and possibly in a region separating the first region from the second region.

In embodiments, when the first semiconductor device is a transistor, the method may comprise during step c2 a step of forming a channel layer and forming a barrier layer over (e.g., on) the channel layer. Further steps in the fabrication of the transistor may be a step of forming a source, a drain, and a gate.

Any features of any embodiment of the first aspect may be independently as correspondingly described for any embodiment of the second aspect of the present invention.

In a second aspect, the present invention relates to a semiconductor structure comprising: a base substrate comprising a first region and a second region, a buffer layer over a surface of the base substrate at least in the first region, wherein the buffer layer comprises at least one monolayer of a first two-dimensional layered crystal material, a III-V semiconductor material over the buffer layer in the first region, and at least part of a further device in the second region. The semiconductor structure of the second aspect is typically obtainable by the method of the first aspect.

In embodiments, the III-V semiconductor material comprises a buffer III-V material over, e.g., on, the buffer layer. In embodiments, the III-V semiconductor material comprises an active III-V material over, e.g., on, the buffer III-V material. In embodiments, the semiconductor structure comprises a protective layer over the III-V semiconductor material. In embodiments, the semiconductor structure comprises a III-V semiconductor device comprising a channel comprising the III-V semiconductor material.

In embodiments, the further device comprises a second two-dimensional layered crystal material. In embodiments, the second two-dimensional layered crystal material may comprise a different material than the first two-dimensional layered crystal material. In embodiments, the further device comprises at least part of the buffer layer in the second region. In these embodiments, the second two-dimensional layered crystal material comprises the same material as the first two-dimensional layered crystal material.

In embodiments, the semiconductor structure comprises a dielectric mask layer over, e.g., on, the surface of the base substrate in the second region. In these embodiments, the dielectric mask layer may be over, e.g., on the buffer layer, when present, in the second region. In particular embodiments, the semiconductor structure comprises the dielectric mask layer over, e.g., on, the surface of the base substrate in the first region. In these embodiments, the buffer layer in the second region may be over, e.g., on the dielectric mask layer in the first region.

Any features of any embodiment of the second aspect may be independently as correspondingly described for any embodiment of the first aspect of the present invention.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

### Example 1: Dielectric mask layer over a buffer layer

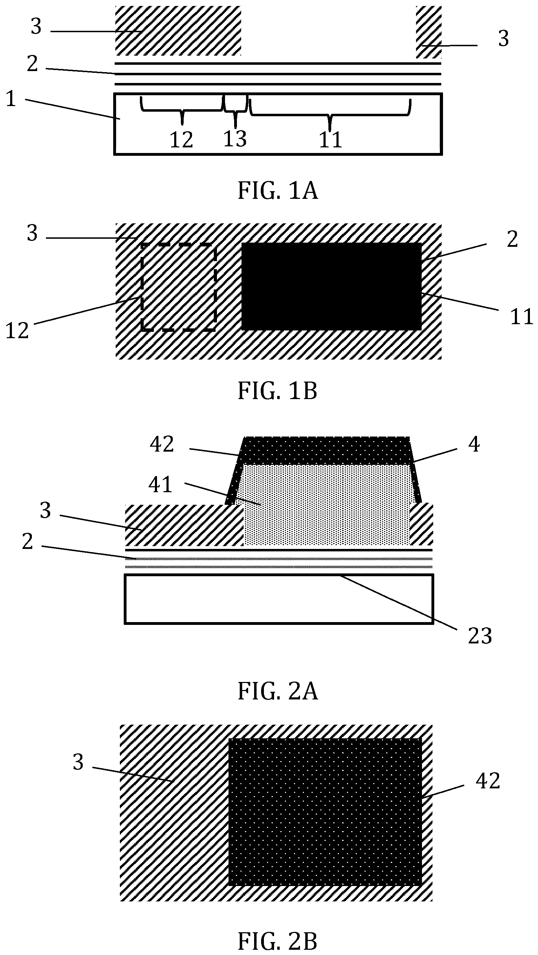

Reference is made to FIG. 1A and FIG 1B. Herein, FIG. 1A is a schematic vertical cross-sectional representation and FIG. 1B is a corresponding schematic top-view representation of an exemplary embodiment of the present invention. In this example, a base substrate 1 is obtained comprising a first region 11 and a second region 12, which are in this example separated from each other by a region 13. A buffer layer 2 is provided on a top surface of the base substrate 1 at least in the first region 11. In the present example, the buffer layer 2 is provided in the first region 11, the second region 12, and in the region 13 separating the first 11 and second region 12. In this example, the buffer layer 2 comprises three monolayers of a first two-dimensional layered crystal material. In this example, a dielectric mask layer 3, e.g., comprising a silicon oxide or a silicon nitride, is deposited on the buffer layer 2, i.e., over the surface of the substrate 1, in the second region 12, on surfaces surrounding the first region 11, such as in the region 13 separating the first 11 from the second region 12. In this example, the dielectric mask layer 3 is not deposited in the first region 11.

Reference is made to FIG. 2A and B. Herein, FIG. 2A is a schematic vertical cross-sectional representation, and FIG. 2B is a corresponding schematic top-view representation of an exemplary embodiment of the present invention. A III-V semiconductor material 4 is selectively deposited on the buffer layer 2 in the first region 11. The III-V semiconductor material 4 is deposited by first depositing a buffer III-V material 41 on the buffer layer 2 in the first region 11. Nucleation for growth, hence growth, of III-V material 4, e.g., buffer III-V material 41, is much slower on the dielectric mask layer 3 than on the buffer layer 2. Preferably, there is no deposition of III-V material 4 on the mask layer 3. Thereby, the buffer III-V material 41 may be selectively deposited in the first region 11, and not, for example, in the second region 12 or in the region 13 separating the first 11 from the second region 12. Subsequently, an active III-V material 42 is selectively deposited on the buffer III-V material 41. The selectivity is due to a faster nucleation, i.e., growth, rate of the buffer III-V material 42 on the buffer III-V material 41 than on the dielectric mask layer 3.

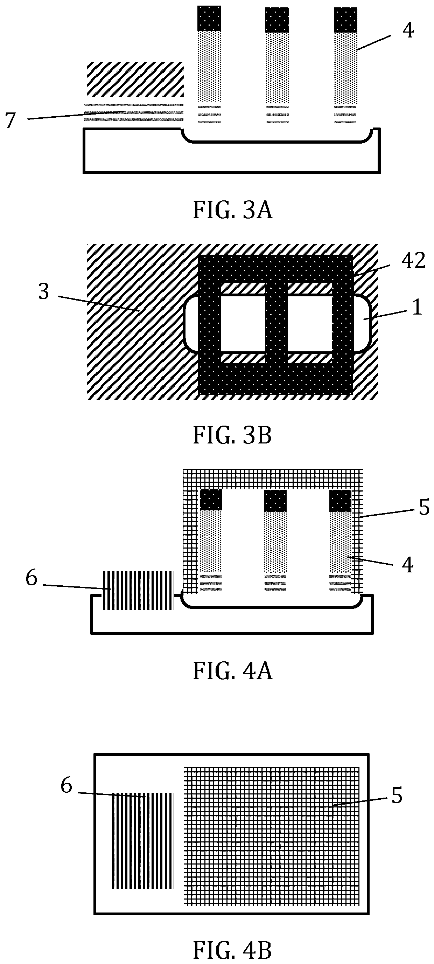

Reference is made to FIG. 3A and B. Herein, FIG. 3A is a schematic vertical cross-sectional representation, and FIG. 3B is a corresponding schematic top-view representation of an exemplary embodiment of the present invention. The III-V semiconductor material 4, and the buffer layer 2 underneath the III-V semiconductor material 4, may be etched so as to form a preferred structure, that is, preferred for the III-V semiconductor device. For example (not shown), a mask comprising a pattern may be formed on the III-V semiconductor material 4, and, subsequently, the pattern may be transferred in the III-V semiconductor material 4 and in the buffer layer 2 underneath the III-V semiconductor material 4, e.g., by application of an etch. Finally, the mask may be removed. Furthermore, an interface area 23 (see also FIG. 2) between the surface of the base substrate 1 in the first region 11 and a surface of the buffer layer 2 in the first region 11 may be reduced, for example by etching.

In particular embodiments, at least part of the first two-dimensional layered crystal material in the second region 12 is retained. Thereby, at least part of the first two-dimensional layered crystal material in the second region 12 may form, i.e., is, a second two-dimensional layered crystal material 7 that is part of a further device in the second region 12.

Reference is made to FIG. 4A and B. Herein, FIG. 4A is a schematic vertical cross-sectional representation, and FIG. 4B is a corresponding schematic top-view representation of an exemplary embodiment of the present invention. In different embodiments, the III-V semiconductor material 4 may be protected with a protective layer 5 that covers tops and sides of the III-V semiconductor material 4. Next, the dielectric mask layer 3 may be removed. Subsequently, the first two-dimensional layered crystal material 2 in the second region 12 is removed. Next, at least part of the further device 6 is formed, e.g., by a Si CMOS technique as is well-known to the skilled person. The Si CMOS technique may yield a further device 6 that is a further semiconductor device.

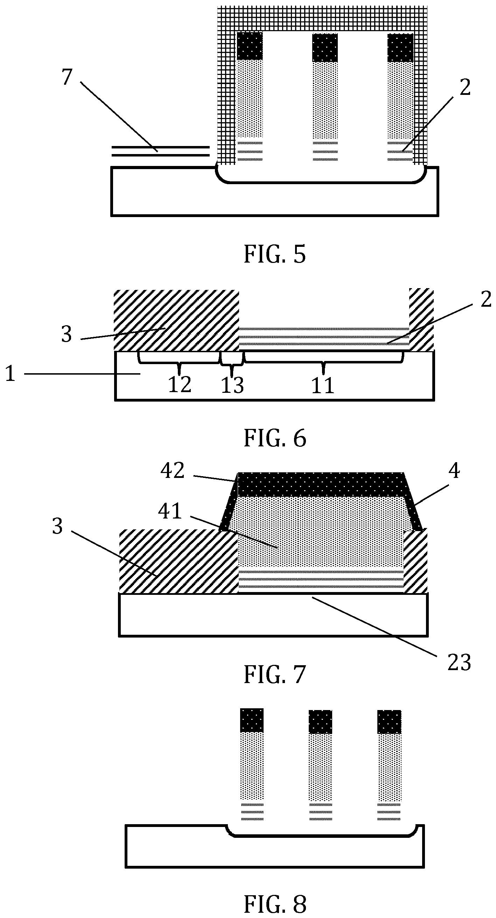

Reference is made to FIG. 5. In still different embodiments, after formation of the protective layer 5, and removal of the dielectric mask layer 3, the first two-dimensional layered crystal material 2 in the second region 12 is removed. Subsequently, in this example, a second two-dimensional layered crystal material 7, which may be a material different from the first two-dimensional layered crystal material 2, may be deposited in the second region 12, possibly selectively only in the second region 12. In this example, the second two-dimensional layered crystal material 7 may form part of the further device in the second region 12. In this example, the second two-dimensional layered crystal material 7 has two monolayers, but the invention is not limited thereto.

### Example 2: Dielectric mask layer as mask for forming a buffer layer

Reference is made to FIG. 6. In this example, a dielectric mask layer 3 is formed on a surface of a base substrate 1 in a second region 12 and not in a first region 11. The dielectric mask layer 3 may further be on surfaces in regions surrounding the first region 11, such as in a region 13 separating the first 11 from the second region 12. Thereby, subsequently, a buffer layer 2 may be selectively formed in the first region 11, but not in the second region 12, preferably not elsewhere on the base substrate. That is, the buffer layer 2 may grow on exposed surfaces of the base substrate 1, but not on a surface of the base substrate 1 covered by the dielectric mask layer 3.

Reference is made to FIG. 7. A buffer III-V material 41 may be formed on the buffer layer 2. Subsequently, an active III-V material 42 may be formed on the buffer III-V material 41, thereby forming the III-V semiconductor material 4.

Reference is made to FIG. 8. As in Example 1, the III-V semiconductor material 4 may be etched. As in Example 1, the interface area 23 (see also FIG. 7) between the base substrate 1 and the buffer layer 2 in the first region 11, i.e., underneath the III-V semiconductor material 4, may be reduced. Next, the dielectric mask layer 3 may be removed, for example after formation of a protective layer 5 over the III-V semiconductor material 4. Finally, at least part of a further device may be formed in the second region 12, similarly to Example 1, e.g., as shown in FIG. 4 or FIG. 5.

### Example 3: Buffer layer on a dielectric mask layer

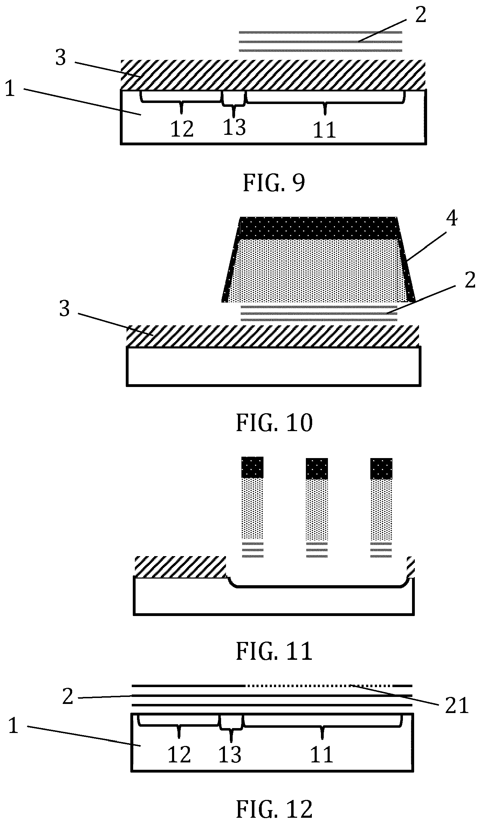

Reference is made to FIG. 9. In this example, a dielectric mask layer 3 is formed over a surface of a base substrate 1 in a first region 11, in a second region 12, and in a region 13 separating the first 11 from the second region 12. For example, the dielectric mask layer 3 may be present on a surface surrounding the first 11 and second 12 regions. Next, a buffer layer 2 may be obtained on the dielectric mask layer 3 in the first region 11. In this example, the buffer layer 2 is not obtained in the second region 12, in the region 13 separating the first 11 from the second region 12, and not in regions surrounding the first 11 and the second region 12. For example, the buffer layer 2 may be exfoliated from an external material and transferred only on the dielectric mask layer 3 in the first region 11. Alternatively, the buffer layer 2 may first be deposited over the dielectric mask layer 3 over the complete surface of the base substrate 1, i.e., in the first 11 and second region 12. Subsequently, the buffer layer 2 may be selectively removed outside of the first region 11.

Reference is made to FIG. 10. A III-V semiconductor material 4 is formed selectively on top of a surface of the buffer layer 2 in the first region 11, selectively on the surface of the buffer layer 2 with respect to a surface of the dielectric mask 3.

Reference is made to FIG. 11. Next, the III-V semiconductor material may be patterned, similarly as in Examples 1 and 2. Subsequently, an interface area between the surface of the dielectric mask layer 3 in the first region 11 and a surface of the buffer layer 2 in the first region 11 is reduced. In this example, at the same time, the dielectric mask layer 3 in the first region is removed. For example, wet etching, using HF, through the same mask as used for patterning the III-V semiconductor material 4 may be used to remove the dielectric mask layer 3 underneath the III-V semiconductor material 4. Finally, at least part of a further device may be formed in the second region 12, similarly as in Examples 1 and 2.

### Example 4: Buffer layer comprising crystallographic defects

Reference is made to FIG. 12. In this example, a buffer layer 2 is obtained on a surface of a base substrate 12 in a first region 11, a second region 12, a region 13 separating the first 11 from the second region 12, and on a surface in region surrounding the first 11 and second region 12. Defects 21 are introduced in the buffer layer 2, e.g., in the top monolayer of the buffer layer, in a first region 11, but not elsewhere.

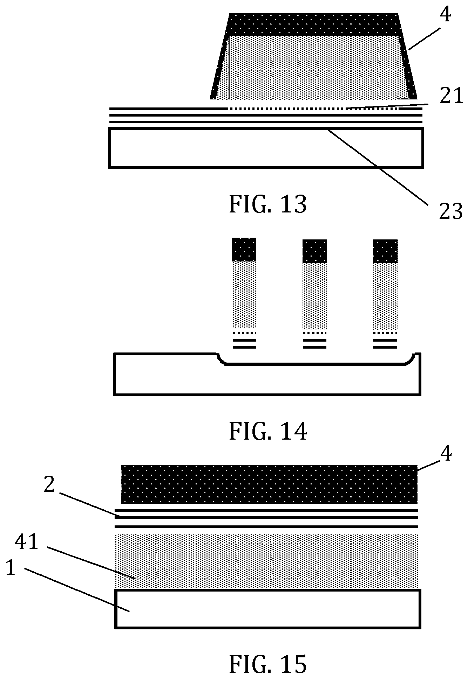

Reference is made to FIG. 13. The defects 21 may serve as nucleation for the formation of a III-V semiconductor material 4. Thereby, the III-V semiconductor device 4 only forms on the buffer layer 2 in the first region 11.

Reference is made to FIG. 14. The III-V semiconductor material 4 and the buffer layer 2 underneath the III-V semiconductor material 4 may be patterned. An interface area 23 between a surface of the base substrate 1 and a surface of the buffer layer 2 in the first region 11 may be reduced. The buffer layer 2 may be removed at least in a second region 12, so as to expose a surface of the base substrate in the second region 12. Finally, at least part of a further may be formed in the second region 12, similarly as in the Examples 1, 2, and 3.

### Example 5: III-V semiconductor device over buffer layer over III-V buffer material

Reference is made to FIG. 15. In this example, first, a III-V buffer material 41 is formed on a surface of a base substrate 1, e.g., in the first region of the base substrate 1. Subsequently, a buffer layer 2 is deposited on the III-V buffer material 41. Finally, a III-V semiconductor material 4 is deposited on top of the buffer layer 2. The III-V semiconductor material 4 may be a monocrystalline III-V semiconductor material, e.g., formed at a temperature of from 1000 to 1200°C. In this example, the buffer layer 2 may function as a back gate contact of a III-V semiconductor device. Alternatively, a III-V buffer material may be deposited on top of the buffer layer 2. In that case, the buffer layer 2 may form a device, embedded in III-V material, wherein a III-V semiconductor material may be also grown on top to form a III-V semiconductor device.

It is to be understood that although preferred embodiments, specific constructions, and configurations, as well as materials, have been discussed herein for devices according to the present invention, various changes or modifications in form and detail may be made without departing from the scope of this invention. Steps may be added or deleted to methods described within the scope of the present invention.

## Claims

1. A method for manufacturing a semiconductor structure comprising a III-V semiconductor device in a first region (11) of a base substrate (1) and at least part of a further device (6) in a second region (12) of the base substrate (1), the method comprising:
a. obtaining a base substrate (1) comprising the first region (11) and the second region (12), different from the first region (11),
b. providing a buffer layer (2) over a surface of the base substrate (1) at least in the first region (11), wherein the buffer layer (2) comprises at least one monolayer of a first two-dimensional layered crystal material,
c. forming, over the buffer layer (2) in the first region (11), and not in the second region (12), a III-V semiconductor material (4), and
d. forming, in the second region (12), at least part of the further device (6).

2. The method according to claim 1, wherein the III-V semiconductor material (4) comprises a III-N semiconductor material, preferably one of GaN, AlN, InN, AlGaN, InGaN, InAlN, and GaInAlN.

3. The method according to any of the previous claims, wherein the base substrate (1) comprises crystalline silicon, preferably Si(100).

4. The method according to any of the previous claims, wherein providing the buffer layer (2) comprises providing the buffer layer (2) over a surface of the base substrate (1) in the first region (11) and in the second region (12).

5. The method according to any of the previous claims, wherein the at least part of the further device (6) comprises a silicon semiconductor material or at least one monolayer of a second two-dimensional layered crystal material (7).

6. The method according to claim 5 dependent on claim 4, wherein the at least part of the further device (6) comprises the buffer layer (2) in the second region (12).

7. The method according to any of the previous claims, comprising a step a' after step a, and before step c of:
a'. forming a dielectric mask layer (3) over the surface of the substrate (1) in the second region (12) and not in the first region (11).

8. The method according to any of the previous claims, comprising a step b' after step b and before step c of:
b'. introducing crystallographic defects (21) in the buffer layer (2) in the first region (11) and not in the second region (12).

9. The method according to any of the previous claims, comprising a step c' after step c of:
c'. reducing an interface area (23) between the surface of the base substrate (1) in the first region (11) and a surface of the buffer layer (2) in the first region (11).

10. The method according to any of the previous claims, comprising a step c" after step c and before step d of:
c". forming a protective layer (5) over the III-V semiconductor material (4).

11. The method according to any of the previous claims, wherein the buffer layer (2) comprises from 1 to 100 monolayers of the first two-dimensional layered crystal material.

12. The method according to any of the previous claims, wherein the monolayer of the first two-dimensional layered crystal material comprises graphene, silicene, borophene, germanene, black phosphorus, hexagonal boron nitride, or a transition metal dichalcogenide monolayer.

13. The method according to any of the previous claims, wherein step c of forming the III-V semiconductor material comprises the steps of:
c1. depositing buffer III-V material (41) at a temperature of from 1000 to 1200 °C, and
c2. depositing an active III-V material (42) on the buffer III-V material (41) at a temperature of from 1210 to 1300°C.

14. The method according to claim 13, wherein, in step c1, less than 1000 nm of buffer III-V material (41) is deposited.

15. A semiconductor structure comprising:
- a base substrate (1) comprising a first region (11) and a second region (12),
- a buffer layer (2) over a surface of the base substrate (1) at least in the first region (11), wherein the buffer layer (2) comprises at least one monolayer of a first two-dimensional layered crystal material,
- a III-V semiconductor material (4) over the buffer layer (2) in the first region (11), and
- at least part of a further device (6) in the second region (12).
